# EUROPEAN PATENT APPLICATION

(11) **EP 4 657 437 A1**
(43) Date of publication of application: **03.12.2025**
(21) Application number: 25179279.2
(22) Date of filing: 28.05.2025
(51) Int. Cl.: G11C 7/12, G11C 7/24, G11C 11/419

(54) **SCRAMBLED DUMMY COLUMN MEMORY ARCHITECTURE FOR AN IN-MEMORY COMPUTATION PROCESSING SYSTEM**

(30) Priority: 31.05.2024 US 202463654161 P; 13.05.2025 US 202519206830
(71) Applicant: STMicroelectronics International N.V., 1228 Plan-les-Ouates, Geneva (CH)
(72) Inventor: RAWAT, Harsh, 121006 Faridabad (IN); CHAWLA, Nitin, 201304 Noida (IN); AYODHYAWASI, Manuj, 201304 Noida (IN)
(74) Representative: Casalonga

(57) **Abstract**

A circuit memory includes sub-arrays with memory cells (storing weight data for an in-memory computation operation) arranged in a row-column matrix where each row includes a word line and each sub-array column includes a local bit line. For in-memory computation operation execution, a control circuit simultaneously actuates one word line per sub-array. An input/output circuit for each column includes bit line inputs to the local bit lines of the sub-arrays and a sub-array data output coupled to each bit line input. Bit lines of the sub-arrays in a dummy column of the memory are precharged to a randomly selected one of first and second voltage levels in connection with execution of the in-memory computation operation to provide a randomization of circuit power consumption as a measure to protect the memory from a side channel attack to extract the weight data.

## Description

### CROSS REFERENCE TO RELATED APPLICATIONS

This application claims priority from United States Provisional Application for Patent No. 63/654,161, filed May 31, 2024, which is incorporated herein by reference.

### TECHNICAL FIELD

Embodiments herein relate to a memory architecture for an in-memory computation processing system and, in particular, to the use of scrambled dummy columns in the memory architecture.

### BACKGROUND

An in-memory computation (IMC) processing system stores information in the bit cells of a memory array and performs calculations at the bit cell level. An example of a calculation performed by an IMC processing system is a multiply and accumulate (MAC) operation where an input array of numbers (X values, also referred to as the feature or coefficient data) are multiplied by an array of computational weights (g values) stored in the memory and the products are added together to produce an output array of numbers (Y values).

By performing these calculations at the bit cell level in the memory, the IMC processing system does not need to move data back and forth between a memory device and a computing device. Thus, the limitations associated with data transfer bandwidth between devices are obviated and the computation can be performed with lower power consumption.

An IMC processing system includes a circuit that utilizes a memory array formed by a plurality of memory cells arranged in a matrix format. Each memory cell is programmed to store a bit of the computational weight data (also referred to as kernel data) for an in-memory compute operation. In an implementation, each bit of the computational weight data has either a logic "1" value or a logic "0" value which is represented, for example, by a logic state programmed into the memory cell.

It is often the case that the computational weight data is highly valuable and proprietary. Persons of bad intent often try to extract the computational weight data using an extraction technique known in the art as a side channel attack which evaluates power consumption during operation of the IMC processing system. There is a need in the art to provide the IMC processing system with protections against side channel attack efforts to decode the details of the computational weight data stored in the memory array.

### SUMMARY

In an embodiment, a circuit comprises: a memory array including a plurality of memory cells arranged in a matrix with plural rows and plural columns, each row including at least one word line connected to memory cells in the row, and each column including at least one bit line connected to memory cells in the column; wherein the memory cells store computational weight data for an in-memory computation operation; wherein said plural columns include at least one dummy column; a word line drive circuit for each row having an output configured to drive the word line of the row; a row decoder circuit configured to actuate one or more of the word line drive circuits during execution of the in-memory computation operation; and a bitline precharge circuit coupled to the at least one bit line of the at least one dummy column, wherein said bitline precharge circuit is configured to precharge said at least one bit line of the at least one dummy column to a randomly selected one of a first voltage level and a second voltage level, different from the first voltage level, in connection with execution of the in-memory computation operation.

In an embodiment, a circuit comprises: a memory array including a plurality of sub-arrays, wherein each sub-array includes memory cells arranged in a matrix with plural rows and plural columns, each row including a word line connected to the memory cells of the row, and each column including a local bit line connected to the memory cells of the column; wherein the memory cells store computational weight data for an in-memory computation operation; wherein said plural columns include at least one dummy column; a word line drive circuit for each row having an output connected to drive the word line of the row; a row decoder circuit coupled to the word line drive circuits; a control circuit configured to control the row decoder circuit to simultaneously actuate one word line per sub-array during the in-memory computation operation; and a bitline precharge circuit coupled to each local bit line in the at least one dummy column, wherein said bitline precharge circuit is configured to precharge the local one bit line in the at least one dummy column to a randomly selected one of a first voltage level and a second voltage level, different from the first voltage level, in connection with execution of the in-memory computation operation.

In an embodiment, a circuit comprises: a memory array including memory cells arranged in a matrix with plural rows and plural columns, each row including a word line connected to the memory cells of the row, and each column including a bit line connected to the memory cells of the column; wherein the memory cells store computational weight data for an in-memory computation operation; wherein said plural columns include at least one dummy column; a word line drive circuit for each row having an output connected to drive the word line of the row; a row decoder circuit coupled to the word line drive circuits; a control circuit configured to control the row decoder circuit to simultaneously actuate plural ones of the word lines with word line signals having pulse widths modulated by feature data of the in-memory computation operation; and a bitline precharge circuit coupled to the bit line in the at least one dummy column, wherein said bitline precharge circuit is configured to precharge the bit line in the at least one dummy column to a randomly selected one of a first voltage level and a second voltage level, different from the first voltage level, in connection with execution of the in-memory computation operation.

### BRIEF DESCRIPTION OF THE DRAWINGS

For a better understanding of the embodiments, reference will now be made by way of example only to the accompanying figures in which:
Figure 1 is a schematic diagram of a circuit supporting both conventional memory access processing and digital in-memory computation processing;
Figure 2 is a circuit diagram of a 6T static random access memory (SRAM) cell used in the circuit of Figure 1;
Figure 3 is a circuit diagram of an 8T SRAM cell used in the circuit of Figure 1;
Figures 3A, 3B, 3C and 3D are circuit diagrams for bitline precharge circuits used in the circuit of Figure 1; and
Figures 4A-4B show block diagrams for embodiments of a column I/O circuit for the memory circuit in Figure 1;
Figure 5 is a schematic diagram of a circuit supporting analog in-memory computation processing; and
Figures 6A, 6B and 6C are circuit diagrams for bitline precharge circuits used in the circuit of Figure 5.

### DETAILED DESCRIPTION OF THE DRAWINGS

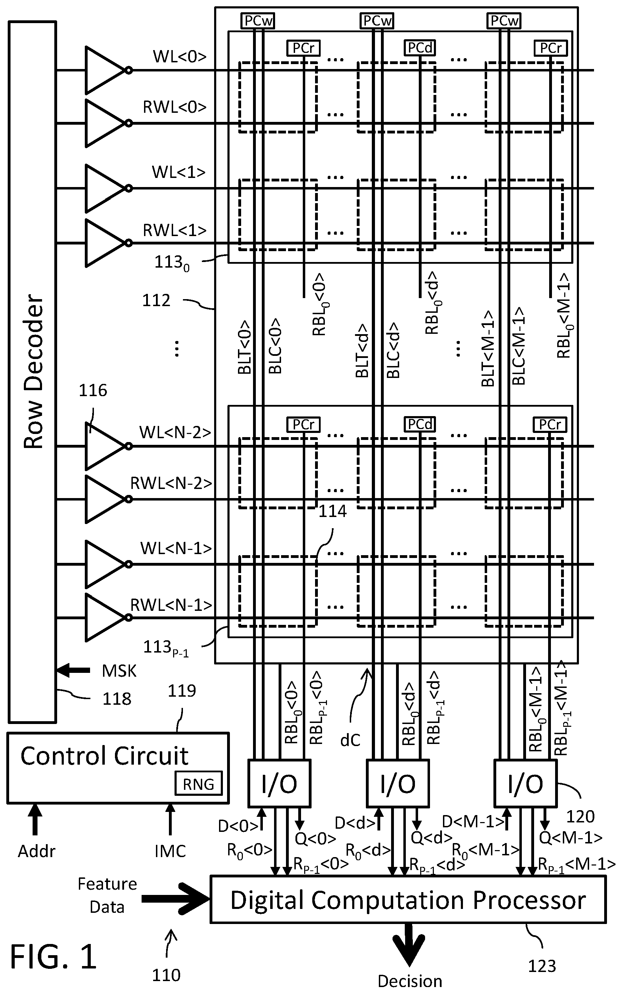

Reference is now made to Figure 1 which shows a block diagram of a circuit 110 supporting both conventional memory access processing and digital in-memory computation processing. The circuit 110 is implemented using a memory circuit which includes a static random access memory (SRAM) array 112 formed by a plurality of SRAM memory cells 114 arranged in a matrix format having N rows and M columns. Each memory cell 114 is programmed to store a bit of data. In conventional memory access processing, the stored data in the memory array 112 can be any desired user data. In digital in-memory computation processing, the stored data in the memory array 112 comprises computational weight or kernel data for a digital in-memory compute operation. In this context, the digital in-memory compute operation is understood to be a form of a high dimensional Matrix Vector Multiplication (MVM) supporting multi-bit weights that are stored in multiple bit cells of the memory. The group of bit cells (in the case of a multibit weight) can be considered as a virtual synaptic element. Each bit of data stored in the memory array, whether user data or weight data, has either a logic "1" or a logic "0" value.

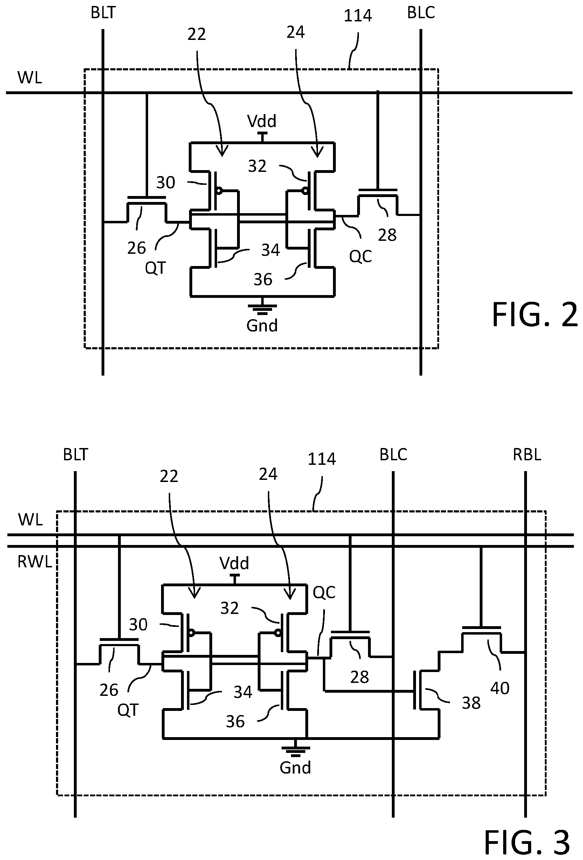

Each SRAM memory cell 114 may comprise a 6T-type memory cell as shown in Figure 2. The cell 114 includes two cross-coupled CMOS inverters 22 and 24, each inverter including a series connected p-channel and n-channel MOSFET transistor pair. The inputs and outputs of the inverters 22 and 24 are coupled to form a latch circuit having a true data storage node QT and a complement data storage node QC which store complementary logic states of the stored data bit. The cell 14 further includes two transfer (passgate) transistors 26 and 28 whose gate terminals are driven by a word line WL. The source-drain path of transistor 26 is connected between the true data storage node QT and a node associated with a true bit line BLT. The source-drain path of transistor 28 is connected between the complement data storage node QC and a node associated with a complement bit line BLC. The source terminals of the p-channel transistors 30 and 32 in each inverter 22 and 24 are coupled to receive a high supply voltage (for example, Vdd) at a high supply node, while the source terminals of the n-channel transistors 34 and 36 in each inverter 22 and 24 are coupled to receive a low supply voltage (for example, ground (Gnd) reference) at a low supply node.

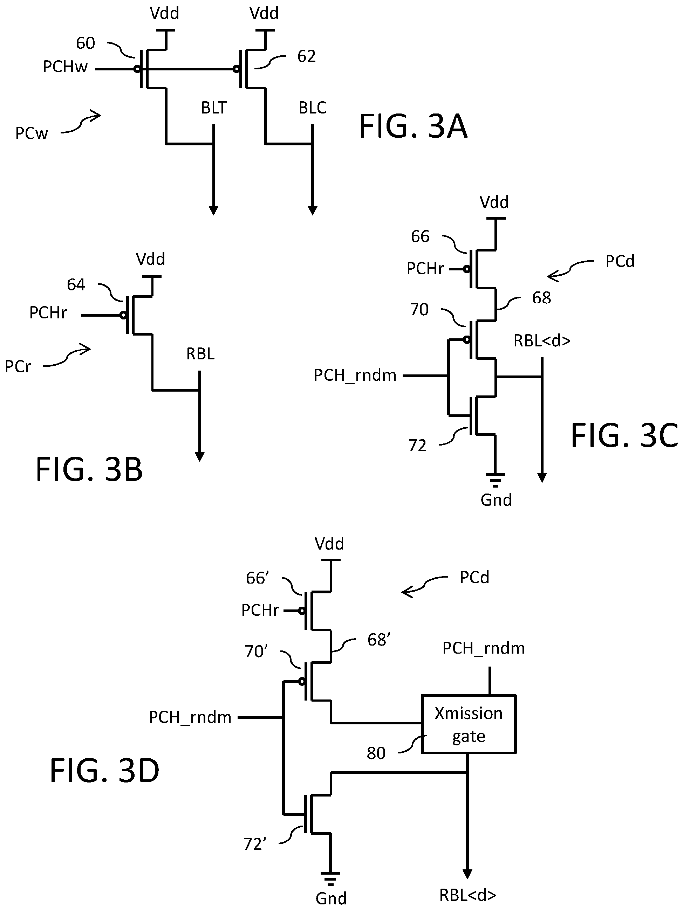

Alternatively, each SRAM memory cell 114 may comprise an 8T-type memory cell as shown in Figure 3. The cell 114 includes two cross-coupled CMOS inverters 22 and 24, each inverter including a series connected p-channel and n-channel MOSFET transistor pair. The inputs and outputs of the inverters 22 and 24 are coupled to form a latch circuit having a true data storage node QT and a complement data storage node QC which store complementary logic states of the stored data bit. The cell 14 further includes two transfer (passgate) transistors 26 and 28 whose gate terminals are driven by a word line WL. The source-drain path of transistor 26 is connected between the true data storage node QT and a node associated with a true bit line BLT. The source-drain path of transistor 28 is connected between the complement data storage node QC and a node associated with a complement bit line BLC. The source terminals of the p-channel transistors 30 and 32 in each inverter 22 and 24 are coupled to receive a high supply voltage (for example, Vdd) at a high supply node, while the source terminals of the n-channel transistors 34 and 36 in each inverter 22 and 24 are coupled to receive a low supply voltage (for example, ground (Gnd) reference) at a low supply node. A signal path between the read bit line RBL and the low supply voltage reference is formed by series coupled transistors 38 and 40. The gate terminal of the (read) transistor 38 is coupled to the complement storage node QC and the gate terminal of the (transfer) transistor 40 is coupled to receive the signal on the read word line RWL.

It will be understood that the circuit 110 may instead use a different type of memory cell, for example any form of a bit cell, storage element or synaptic element supporting read and write operations and producing a deterministic readout arranged in an array. As a non-limiting example, consideration is made for the use of a non-volatile memory (NVM) cell such as, for example, magnetoresistive RAM (MRAM) cell, Flash memory cell, phase change memory (PCM) cell or resistive RAM (RRAM) cell). In the following discussion, focus is made on the implementation using an 8T-type SRAM cell 114, but this is done by way of a non-limiting example, understanding that any suitable memory element could be used (e.g., a binary (two level) storage element or an m-ary (multi-level) storage element).

Each cell 114 includes a word line WL, a pair of complementary bit lines BLT and BLC, a read word line RWL and a read bit line RBL. The SRAM memory cells in a common row of the matrix are connected to each other through a common word line WL and through a common read word line RWL. Each of the word lines (WL and/or RWL) is driven by a word line driver circuit 116 with a word line signal generated by a row decoder circuit 118 during read and write operations. The SRAM memory cells in a common column of the matrix across the whole array 112 are connected to each other through a common pair of complementary (write) bit lines BLT and BLC. The array 112 is segmented into P sub-arrays 113₀ to 113_{P-1}. Each sub-array 113 includes M columns and N/P rows of memory cells 114. The SRAM memory cells in a common column of each sub-array 113 are connected to each other through a local read bit line RBL.

The P local read bit lines RBL₀<x> to RBL_{P-1}<x> from the sub-arrays 113 for the column x in the array 112 are coupled, along with the common pair of complementary bit lines BLT<x> and BLC<x> for the column x in the array 112, to a column input/output (I/O) circuit 120(x). Here, x= 0 to M-1. A data input port (D) of the column I/O circuit 120 receives input data (user or weight data) to be written to an SRAM memory cell 114 in the column through the pair of complementary bit lines BLT, BLC in response to assertion of a word line signal in a conventional memory access mode of operation. A data output port (Q) of the column I/O circuit 120 generates output data read from an SRAM memory cell 14 in the column through the read bit line RBL in response to assertion of a read word line signal in the conventional memory access mode of operation. Additionally, the column I/O circuit 120 further includes P sub-array data output ports R₀ to R_{P-1} to generate output data read from a memory cell 114 on the local read bit line RBL of the corresponding sub-array 113₀ to 113_{P-1}, respectively, in response to the simultaneous assertion of a plurality of read word line signals (one per sub-array 113) in a digital in-memory compute mode of operation. A digital computation processing circuit 123 performs digital computations on the output data from the sub-array data output ports R as a function of received feature data and generates a decision output for the digital in-memory compute operation. The processing circuit 123 can implement computation logic for the digital signal processing in a number of ways including: full support of Boolean operations (XOR, XNOR, NAND, NOR, etc.) and vector operations depending on system and application needs; accumulation pipeline operations where vector multiplication is supported within the memory; and matrix vector multiplication pipeline operations where output from the memory as one vector for the multiply and accumulate (MAC) function. It will be noted that the processing circuit 123 is an integral part of the digital in-memory computation circuit 110.

The computation logic for the digital signal processing performed by processing circuit 123 is closely integrated with the input/output circuits and the sub-array data output ports R₀ to R_{P-1} to support utilization of a wide (for example, P times) vector access. There are a number of figure of merit (FOM) benefits which accrue from this solution including: enabling multi-word access in a same cycle amortizes the common logic toggling power inside the SRAM when wide vector access occurs; the use of sub-arrays 113 can reduce bit line toggling power consumption (i.e., where P word lines are asserted in parallel to access P corresponding sub-arrays); support of both, with the opportunity to toggle between, the conventional memory access mode of operation and the digital in-memory compute mode of operation; and on/off current ratio on the same bitline improves which is a key concern when the circuitry is implemented using fully-depleted silicon-on-insulator (FDSOI) technology where forward body bias is aggressively used.

It will be noted that the circuit 110 presents a conventional SRAM interface through the data input ports D and the data output ports Q in accordance with the conventional memory access mode of operation. In response to an applied memory address (Addr), the circuit supports read (via data output ports Q) and write (via data input ports D) access to a single row of memory cells 114 in the array 112 by the selected assertion of a single word line WL or RWL. The circuit further presents a sub-array processing interface through the sub-array data output ports R₀ to R_{P-1} in accordance with the digital in-memory compute mode of operation. In response to an applied memory address (Addr), the circuit supports simultaneous read (via data output ports R₀ to R_{P-1}) access to a single row of memory cells 114 in each of the sub-arrays 113₀ to 113_{P-1} by the simultaneous assertion of corresponding read word lines RWL. A single address can be decoded to select the plural word lines (one per sub-array 113) for assertion, or plural addresses can be decoded to select the plural word lines (one per sub-array 113) for assertion. The use plural sub-arrays 113 in this mode enables parallelism supporting very wide access for computation processing without sacrificing density. Advantageously, this digital in-memory compute mode of operation utilizes the resources of the conventional SRAM design with modified control, decoding and input/output circuits (as will be discussed herein in detail) to enable parallel access in the digital in-memory compute mode of operation with additional control to toggle between the conventional memory access mode of operation and the digital in-memory compute mode of operation as needed by the system application. This architecture brings parallelism with usage of the push rule bitcell thus enabling high density/compute density when configured for the in-memory compute mode of operation. Notwithstanding the foregoing, as noted above, usage of other bitcell types may instead be made.

A control circuit 119 controls mode operations of the circuitry within the circuit 110 responsive to the logic state of a control signal IMC. When the control signal IMC is in a first logic state (for example, logic low), the circuit 110 operates in accordance with the conventional memory access mode of operation (for writing data from data input port D to the memory array or reading data from the memory array to data output port Q). Conversely, when the control signal IMC is in a second logic state (for example, logic high), the circuit 110 operates in accordance with the digital in-memory compute mode of operation (for reading weight data from the memory array to the sub-array data output ports R).

When the circuit 110 is operating in the conventional memory access mode of operation, the row decoder circuit 118 decodes a received address (Addr), selectively actuates only one word line WL (during write) or one read word line RWL (during read) for the whole array 112 with a word line signal pulse to access a corresponding single one of the rows of memory cells 114. In write, logic states of the data at the input ports D are written by the column I/O circuits 120 through the pairs of complementary bit lines BLT, BLC to the single row of memory cells coupled to the accessed word line WL. In read, the logic states of the data stored in the single row of memory cells coupled to the accessed word line WL are output from the read bit lines RBL to the column I/O circuits 120 for output at the data output ports Q.

When the circuit 110 is operating in the digital in-memory compute mode of operation, the row decoder circuit 118 decodes a received address (Addr), selectively (and simultaneously) actuates one read word line RWL in each sub-array 113 in the memory array 112 with a word line signal pulse to access a corresponding row of memory cells 114 in each sub-array 113. The logic states of the weight data stored in the row of memory cells coupled to the accessed read word line RWL in each sub-array 113 are passed from the read bit lines RBL₀<x> to RBL_{P-1}<x> to the column I/O circuit 120 for output at the corresponding sub-array data output ports R₀ to R_{P-1}.

It will be noted that each sub-array 113 output can be considered as one subtensor/tensor for processing operations. Additionally, multiple sub-arrays 113 outputs can be grouped as a larger tensor. The grouping of sub-array outputs can be made across columns, across rows, or both. Such processing is supported through the configuration and operation of the processing circuit 123.

The architecture shown in Figure 1 presents a number of advantages for digital in-memory computation including: very wide vector access is enabled for supporting high dimensional tensor processing for an artificial neural network (ANN); hyper dimensional computing for artificial intelligence (AI) training and inference workloads is also supported; the computation is deterministic with a wide range of weight data and feature data precisions and number formats permitted for neural network applications (noting that this is a significant differentiation versus analog in-memory computation - which is limited to simplified signed/unsigned integer formats); and the solution is extendable to incorporate additional stochastic compute modes to gain area and power efficiency.

As previously noted, the array 112 includes M columns of memory cells 114. One or more of the columns of memory cells 114 is designed as, or may be selectively configured to function as, a dummy column dC (the remaining columns being referred to as normal columns). In the implementation shown in Figure 1, one such dummy column is provided by the complementary bit lines, memory cells and read bit lines indicated by the suffix <d>. Although this dummy column dC is shown as being located between the first (suffix <0>) and last (suffix <M>) columns of the array, this is by example only as it will be understood that the dummy column may be included in the array at any desired column location. Furthermore, although only one dummy column dC is shown in the array, this is by example only as it will be understood that two or more dummy columns may be included in the array. When two or more dummy columns dC are included, those dummy columns may be located adjacent to each other or spread apart from each other in the array. The location of the one or more dummy columns dC of memory cells 114 in the array may be randomly selected by the circuit designer, or selected when configuring the memory architecture, and the control circuit would be programmed with configuration information identifying the number and location of the dummy columns dC. In a preferred implementation less than 10% of the total M number of columns would be designated as dummy columns in order to limit the impact of dummy column presence on circuit area. In some implementations, dummy columns dC may be dynamically allocated in the array in order to permit those columns to otherwise be part of system bandwidth in scenarios where the dummy column functionality is not required (for example, where there is a reduced security concern with respect to the stored data or there is a need for more processing bandwidth).

The memory array 112 further includes a bit line precharge circuit PCw coupled to the complementary bit lines BLT, BLC of each column of the array. This precharge circuit PCw operates to precharge a desired voltage level (for example, supply voltage Vdd) to the complementary bit lines BLT, BLC in advance of performing a data write operation. Figure 3A shows circuit diagram for an example precharge circuit PCw. The precharge circuit PCw includes a first p-channel MOS transistor 60 having a source coupled to the supply voltage Vdd and a drain coupled to the bit line BLT. The precharge circuit PCw further includes a second p-channel MOS transistor 62 having a source coupled to the supply voltage Vdd and a drain coupled to the bit line BLC. The gates of the transistors 60, 62 are driven by a precharge control signal PCHw that is asserted (logic low) by the control circuit 119 to define the default state of the complementary bit lines prior to beginning (e.g., the execution of) a memory access operation to write data into the memory array. It will be noted that user/system can define the data pattern to be written in each dummy column dC. The data pattern may, for example, be randomly generated.

The memory array 112 further includes a bit line precharge circuit PCr coupled to the read bit line RBLT of each column of each sub-array 113 of the array. This precharge circuit PCr operates to precharge a desired voltage level (for example, supply voltage Vdd) to the read bit line RBL in advance of performing a data read operation or an in-memory computation operation. Figure 3B shows circuit diagram for an example precharge circuit PCr. The precharge circuit PCr includes a p-channel MOS transistor 64 having a source coupled to the supply voltage Vdd and a drain coupled to the read bit line RBL. The gate of the transistor 64 is driven by a read/IMC mode precharge control signal PCHr that is asserted (logic low) by the control circuit 119 to define the default state of the read bit line RBL (at the Vdd level in this example) at the beginning (e.g., the execution of) a memory access operation. During the read operation, the control signal PCHr is deasserted (logic high). Following completion of the read operation, the control signal PCHr is again asserted.

The memory array 112 further includes a bit line precharge circuit PCd coupled to the dummy read bit line RBL of each dummy column dC of each sub-array 113 of the array. This precharge circuit PCd operates to randomly precharge the dummy read bit line RBL to one of a first voltage level (for example, supply voltage Vdd) and a second voltage level (for example, ground voltage Gnd) in advance of performing (i.e., in connection with the execution of) a data read operation or an in-memory computation operation. Figure 3C shows circuit diagram for an example precharge circuit PCd. The precharge circuit PCd includes a first p-channel MOS transistor 66 having a source coupled to the supply voltage Vdd and a drain coupled to the intermediate node 68, a second p-channel MOS transistor 70 having a source coupled to the intermediate node 68 and a drain coupled to the read bit line RBL, and an n-channel MOS transistor 72 having a drain coupled to the intermediate node 68 and a source coupled to the ground voltage Gnd. The gate of the transistor 66 is driven by the read/IMC mode precharge control signal PCHr that is asserted (logic low) by the control circuit 119 in connection with defining the default state of the read bit line RBL before beginning (e.g., the execution of) a memory access operation to read data from the memory array or before beginning (e.g., the execution of) each in-memory computation operation. The gates of the transistors 70 and 72 are driven by a precharge control signal PCH_rndm before beginning either a memory access operation to read data from the memory array or perform an in-memory computation operation. The logic state ("1" or "0") of the precharge control signal PCH_rndm is randomly generated by the control circuit 119 using a random number generator (RNG) circuit at each instance of an access to the memory (read or IMC). When the precharge control signal PCH_rndm is logic "0", and the precharge control signal PCHr is asserted (logic low), the dummy read bit line RBL is precharged to the supply voltage Vdd and the dummy column dC contributes to the power consumption during the read or in-memory computation operation. On the other hand, when the precharge control signal PCH_rndm is logic "1", and the precharge control signal PCHr is asserted (logic low), the dummy read bit line RBL is precharged to the ground voltage Gnd and the dummy column dC does not contribute to the power consumption during the read or in-memory computation operation. Because the logic state of the precharge control signal PCH_rndm is randomly selected (using the random number generator RNG), there is a corresponding random participation of the dummy column dC in the read or in-memory computation operation, and this introduces a random variation in the power waveform of the in-memory computation device making it more difficult for a power-based side channel attack to succeed in discerning the stored computational weight data.

In a modified embodiment, the transistor 70 can be omitted. Thus, when the precharge control signal PCH_rndm is logic "0", and the precharge control signal PCHr is asserted (logic low), the dummy read bit line RBL is precharged to the supply voltage Vdd and the dummy column dC contributes to the power consumption during the read or in-memory computation operation. On the other hand, when the precharge control signal PCH_rndm is logic "1", and the precharge control signal PCHr is asserted (logic low), the dummy read bit line RBL is now floating during the read or in-memory computation operation.

It will be noted that an effect of forcing the dummy read bit line RBL to ground voltage Gnd acts like a masking of the stored data bit since the bit logic value is forced to logic low and this will lead to an output of logic low when multiplied by the feature date for the in-memory computation operation. The effect is then to mask the computation operations of the dummy column dC.

Another circuit example providing for such column masking is provided in Figure 3D which shows a circuit diagram for a further embodiment of the precharge circuit PCd. The precharge circuit PCd includes a first p-channel MOS transistor 66' having a source coupled to the supply voltage Vdd and a drain coupled to the intermediate node 68', a second p-channel MOS transistor 70' having a source coupled to the intermediate node 68' and a drain coupled to the input of a transmission gate circuit 80. An output of the transmission gate circuit 80 is coupled to the read bit line RBL. An n-channel MOS transistor 72' has a drain coupled to the read bit line RBL and a source coupled to the ground voltage Gnd. The gate of the transistor 66' is driven by the read/IMC mode precharge control signal PCHr that is asserted (logic low) by the control circuit 119 in connection with defining the default state of the read bit line RBL before beginning (e.g., the execution of) a memory access operation to read data from the memory array or before beginning (e.g., the execution of) each in-memory computation operation. The gates of the transistors 70' and 72' are driven by a precharge control signal PCH_rndm at before beginning either a memory access operation to read data from the memory array or perform an in-memory computation operation. The precharge control signal PCH_rndm is also applied as an operational control signal for the transmission gate circuit 80. The logic state ("1'' or "0") of the precharge control signal PCH_rndm is randomly generated by the control circuit 119 using a random number generator (RNG) circuit at each instance of an access to the memory (read or IMC). The column can be configured for operation by enabling operation of (i.e., turning ON) the transmission gate circuit 80. However, when the transmission gate circuit 80 is turned OFF, the column is masked and the read bit line RBL is driven to the logic low state. When in the enabled configuration, with the precharge control signal PCH_rndm at logic "0", and the precharge control signal PCHr asserted (logic low), the dummy read bit line RBL is precharged to the supply voltage Vdd and the dummy column dC contributes to the power consumption during the read or in-memory computation operation. On the other hand, when the precharge control signal PCH_rndm is logic "1", and the precharge control signal PCHr is asserted (logic low), the dummy read bit line RBL is precharged to the ground voltage Gnd and the dummy column dC does not contribute to power consumption during the read or in-memory computation operation. Because the logic state of the precharge control signal PCH_rndm is randomly selected (using the random number generator RNG), there is a corresponding random participation of the dummy column dC in the in-memory computation operation, and this introduces a random variation in the power waveform of the in-memory computation device making it more difficult for a power-based side channel attack to succeed in discerning the stored computational weight data.

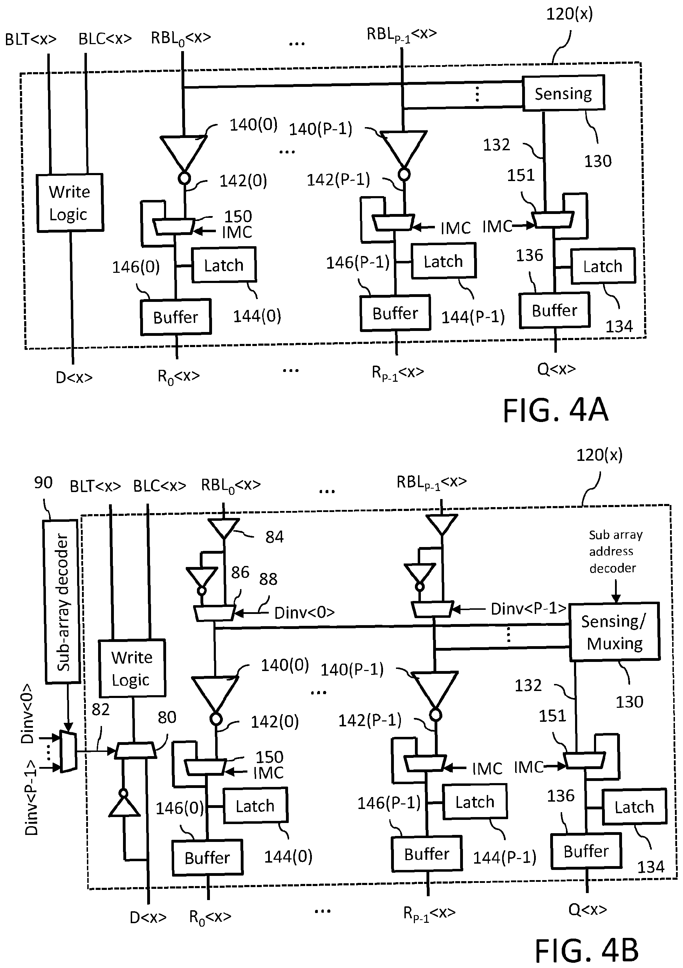

A block diagram of an embodiment for the column I/O circuit 120 is shown in Figure 4A. The column I/O circuit 120(x) is coupled to the pair of complementary bit lines BLT<x>, BLC<x> for the column x in the array 112. The bit at the data input port D<x> is coupled through a write logic circuit to drive the pair of complementary bit lines. The column I/O circuit 120(x) is also coupled to the P local read bit lines RBL₀<x> to RBL_{P-1}<x> from the sub-arrays 113 for the column x in the array 112 through a read logic circuit.

A sensing circuit 130 of the read logic circuit is coupled to receive the data on the P local read bit lines RBL₀<x> to RBL_{P-1}<x> and generate a sensed data bit on signal line 132. As an example, the sensing circuit 130 may comprise a logic NAND gate. The sensed data bit is applied to the first input of a multiplexer circuit 151 whose select input receives the control signal IMC. The second input of the multiplexer circuit 151 is coupled to the output of the multiplexer circuit 151. The data at the output of multiplexer circuit 151 is latched by latch circuit 134 and buffered by buffer circuit 136 for output at the data output port Q<x>. When the control signal IMC is in the first logic state (for example, logic low - when the circuit 110 is operating in accordance with the conventional memory access mode of operation), the multiplexer circuit 151 selects the data on signal line 132. Conversely, when the control signal IMC is in the second logic state (for example, logic high - when the circuit 110 is operating in accordance with the digital in-memory compute mode of operation), the multiplexer circuit 151 selects the data at the output of the multiplexer circuit 151 (i.e., the data held by the latch 134).

A sensing circuit 140(y) of the read logic circuit is coupled to receive the data on the local read bit line RBL_{y}<x> and generate a sensed data bit on signal line 142(y). Here, y = 0 to P-1. As an example, each sensing circuit 140 may comprise a logic NOT gate. The sensed data bit is applied to the second input of a multiplexer circuit 150 whose select input receives the control signal IMC. The first input of the multiplexer circuit 150 is coupled to the output of the multiplexer circuit 150. The data at the output of multiplexer circuit 150 is latched by latch circuit 144(y) and buffered by buffer circuit 146(y) for output at the sub-array data output port R_{y}<x>. When the control signal IMC is in the first logic state (for example, logic low - when the circuit 110 is operating in accordance with the conventional memory access mode of operation), the multiplexer circuit 150 selects the data at the output of the multiplexer circuit 150 (i.e., the data held by the latch 144). Conversely, when the control signal IMC is in the second logic state (for example, logic high - when the circuit 110 is operating in accordance with the digital in-memory compute mode of operation), the multiplexer circuit 150 selects the data on signal line 142.

Figure 4B shows a block diagram of another embodiment for the column I/O circuit 120. Same references in Figures 4A and 4B refer to same or similar components, the description of which will not be repeated. The circuit 120 of Figure 4B differs from the circuit 120 of Figure 4A primarily in connection with supporting polarity control for weight data stored in the memory cells 114. It will be noted that when the memory cell 114 stores a logic 0 (i.e., QT=0, QC=1), the read bit line RBL will be discharged to ground. Conversely, when the memory stores a logic 1, the read bit line RBL is not discharged. Thus, there is a gain in power of about 50% when memory cell stores logic 1. This fact can be advantageously used to reduce power consumption of the circuit 110. In a neural network application, the weight data that is written to the memory cells is pre-known, and because of this it can be selectively written to the memory in a least power state (i.e., emphasizing the storage of logic 1's over the storage of logic 0's). So, if a given set of weight data includes more bits at logic 0 than at logic 1, this weight data can be inverted and then stored in that inverted state in order to achieve a power gain. With that data stored inverted, however, it must be inverted after reading from the memory array to return to its original logic state. The circuit implementation shown in Figure 4B achieves this processing.

The data bit at the input port D<x> is applied to the first input of a multiplexer 80 and a logical inversion of the data bit is applied to the second input of the multiplexer 80. The selection input of the multiplexer 80 receives a selection signal 82 whose logic state is dependent on whether the bit or the logical inversion of the bit is to be written by the write logic circuit to the memory cell over the bit lines BLT, BLC.

The data bit on the local read bit line RBL_{y}<x> is buffered by a buffer circuit 84 and applied to the first input of a multiplexer 86 and a logical inversion of the buffered data bit is applied to the second input of the multiplexer 86. The selection input of the multiplexer 86 receives a selection signal 88 whose logic state is dependent on whether the bit or the logical inversion of the bit is to be read from the memory cell over the read bit line.

In connection with performing the operation to write weight data to the memory, a determination is made as to whether, for a given row of memory cells or for a given sub-array, there are more logic 1 bits or more logic 0 bits. In the case where there are more logic 0 bits, the selection signal 82 has a logic state to control the multiplexer circuits 80 of the column I/O circuits 120 to select the logical inversion of the data bits and those logically inverted data bits are written to the memory. A record of this is kept by the system 110 so that whenever an in-memory compute operation accesses weight data stored as logically inverted, the selection signal 88 has a logic state to control the multiplexer circuits 86 of the column I/O circuits 120 to select the logical inversion of the data bits and those logically inverted data bits are processed by the sensing circuits 140.

Consider the example where logic state analysis of the weight data is made at the level of the sub-array 113. If the weight data to be stored in a given sub-array includes more logic 0 bits, the data inversion signal Dinv for that sub-array is latched in an asserted state. Responsive to sub-array decoder 90 selection of that sub-array for a data write operation, a multiplexer circuit 92 is controlled to select the asserted data inversion signal Dinv for application as signal 82 and the multiplexer 80 selects the logically inverted data bit for writing to the memory. Responsive to a data read in connection with an in-memory compute operation, the asserted data inversion signal Dinv is applied as signal 88 and the multiplexer 86 selects the logically inverted data bit for read from the memory.

It will be noted that polarity inversion control can be specific to a group of subtensor segments that make up the full tensor readout. Because the logic states of the weight data are pre-known, the logic states of the data inversion signals Dinv can be selected and latched. Data polarity control can be made specific to each sub-tensor array in order to control the state of the data stored in each row of the sub-array (acting as on subtensor/tensor) based on data sparsity.

The example shown in Figure 4B provides a separate data inversion signal for each sub-array, with that signal shared across all the I/O circuits 120. The logic state of the data inversion signal is controlled by the system 110 based the analysis of the logic states of the pre-known weight data arrangement.

The digital computation processor 123 may include a multiplexing functionality that would select for the computation processing only the outputs from the normal columns (i.e., the not dummy columns dC by masking off output from the one or more dummy columns dC to ensure those outputs do not contribute the calculated decision). In cases with limited or shared I/O circuit 120 resources, this multiplexing functionality would be located between the array 112 and the inputs to the I/O circuits 120 in order to select only output from the normal columns for input I/O processing.

Although the foregoing discussion indicates a distinct use of the dummy columns dC, it will be understood that the circuitry of the dummy columns could be implementation to enable support as normal operation columns. For example, this may be implemented in situations where increased bandwidth for in-memory computation operations is needed. In other words, the control circuit of the system may selectively configure certain columns as dummy columns in support of a given processing operation, and then change to have those same certain columns configured as normal columns in connection with supporting a different processing operation.

Additionally, in connection with the column masking function noted above, the control circuit of the system may selectively configure certain columns to be masked from participating in a processing operation.

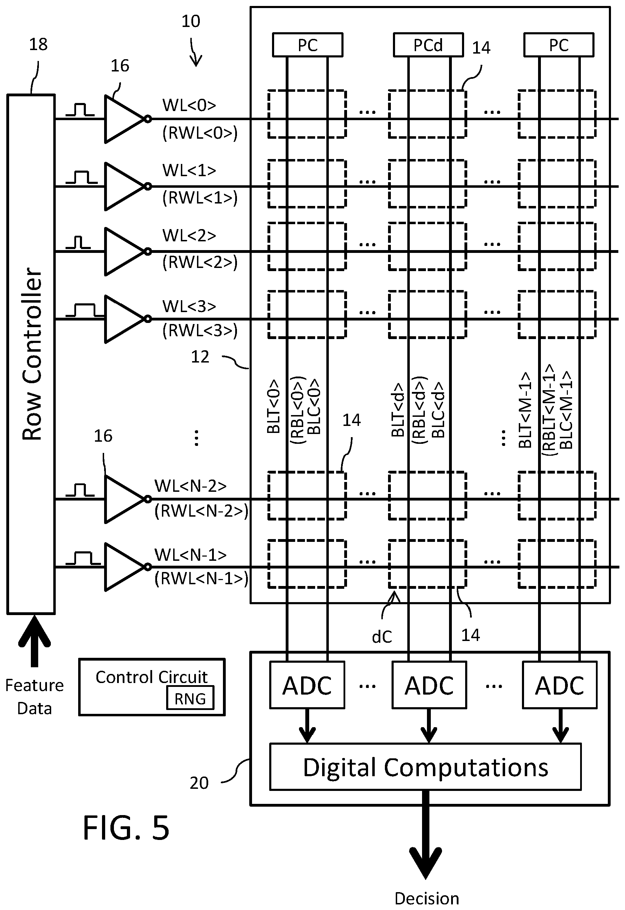

Reference is now made to Figure 5 is a schematic diagram of a circuit 10 supporting analog in-memory computation processing. The circuit 10 utilizes a memory circuit including a static random access memory (SRAM) array 12 formed by standard 6T SRAM memory cells 14 (see, Figure 2) arranged in a matrix format having N rows and M columns. As an alternative, a standard 8T memory cell (see, Figure 3) or an SRAM with a similar functionality and topology could instead be used. Each memory cell 14 is programmed to store a bit of a computational weight or kernel data for an in-memory compute operation. In this context, the in-memory compute operation is understood to be a form of a high dimensional Matrix Vector Multiplication (MVM) supporting multi-bit weights that are stored in multiple bit cells of the memory. The group of bit cells (in the case of a multibit weight) can be considered as a virtual synaptic element. Each bit of the computational weight has either a logic "1" or a logic "0" value.

Each SRAM cell 14 includes a word line WL and a pair of complementary bit lines BLT and BLC. The 8T-type SRAM cell would additionally include a read word line RWL and a read bit line RBL. The cells 14 in a common row of the matrix are connected to each other through a common word line WL (and through the common read word line RWL in the 8T-type implementation). The cells 14 in a common column of the matrix are connected to each other through a common pair of complementary bit lines BLT and BLC (and through the common read bit line RBL in the 8T-type implementation). Each word line WL, RWL is driven by a word line driver circuit 16 which may be implemented as a CMOS driver circuit (for example, a series connected p-channel and n-channel MOSFET transistor pair forming a logic inverter circuit). The word line signals applied to the word lines, and driven by the word line driver circuits 16, are generated from feature data input to the in-memory computation circuit 10 and controlled by a row controller circuit 18. A column processing circuit 20 senses the analog signals on the pairs of complementary bit lines BLT and BLC (and/or on the read bit line RBL) for the M columns, converts the analog signals to digital signals (using analog-to-digital converter (ADC) circuits), performs digital calculations on the digital signals and generates a decision output for the in-memory compute operation.

It will be understood that the circuit 10 may instead use a different type of memory cell, for example, any form of a bit cell, storage element or synaptic element. As a non-limiting example, consideration is made for the use of a non-volatile memory (NVM) cell such as, for example, magnetoresistive RAM (MRAM) cell, Flash memory cell, phase change memory (PCM) cell or resistive RAM (RRAM) cell). In the following discussion, focus is made on the implementation using an 8T-type SRAM cell 14, but this is done by way of a non-limiting example, understanding that any suitable memory element could be used (e.g., a binary (two level) storage element or an m-ary (multi-level) storage element).

Although not explicitly shown in Figure 5, it will be understood that the circuit 10 further includes conventional row decode, column decode, and read-write circuits known to those skilled in the art for use in connection with writing bits of data (for example, the computational weight data) to, and reading bits of data from, the SRAM cells 14 of the memory array 12. This operation is referred to as a conventional memory access mode and is distinguished from the analog in-memory compute operation discussed above.

The row controller circuit 18 receives the feature data for the in-memory compute operation and in response thereto performs the function of selecting which ones of the read word lines RWL<0> to RWL<N-1> are to be simultaneously accessed (or actuated) in parallel during an analog in-memory compute operation, and further functions to control application of pulsed signals to the word lines in accordance with that in-memory compute operation. Figure 5 illustrates, by way of example only, the simultaneous actuation of all N word lines with the pulsed word line signals, it being understood that in-memory compute operations may instead utilize a simultaneous actuation of fewer than all rows of the SRAM array. The analog signals on the read bit lines RBL are dependent on the logic state of the bits of the computational weight stored in the memory cells 14 of the corresponding column and the width(s) of the pulsed word line signals applied to those memory cells 14.

The implementation illustrated in Figure 5 shows an example in the form of a pulse width modulation (PWM) for the applied word line signals for the in-memory compute operation dependent on the received feature data. The use of PWM or period pulse modulation (PTM) for the applied word line signals is a common technique used for the in-memory compute operation based on the linearity of the vector for the multiply-accumulation (MAC) operation. The pulsed word line signal format can be further evolved as an encoded pulse train to manage block sparsity of the feature data of the in-memory compute operation. It is accordingly recognized that an arbitrary set of encoding schemes for the applied word line signals can be used when simultaneously driving multiple word lines. Furthermore, in a simpler implementation, it will be understood that all applied word line signals in the simultaneous actuation may instead have a same pulse width.

A control circuit controls mode operations of the circuitry within the circuit 10.

As previously noted, the array 12 includes M columns of memory cells 14. One or more of the columns of memory cells 14 is designed as a dummy column dC (the remaining columns referred to as normal columns). In the implementation shown in Figure 5, one such dummy column is provided by the complementary bit lines, memory cells and read bit lines indicated by the suffix <d>. Although this dummy column dC is shown as being located between the first (suffix <0>) and last (suffix <M>) columns of the array, this is by example only as it will be understood that the dummy column may be included in the array at any desired column location. Furthermore, although only one dummy column dC is shown in the array, this is by example only as it will be understood that two or more dummy columns may be included in the array. When two or more dummy columns dC are included, those dummy columns may be located adjacent to each other or spread apart from each other in the array. The location of the one or more dummy columns dC of memory cells 14 in the array may be randomly selected by the circuit designer, and the control circuit would be programmed with configuration identifying number and location of the dummy columns dC. In a preferred implementation less than 10% of the total M number of columns would be designated as dummy columns in order to limit the impact of dummy column presence on circuit area. In some implementations, dummy columns dC may be dynamically allocated in the array in order to permit the columns to otherwise be part of system bandwidth in scenarios where the dummy column functionality is not required (for example, where there is a reduced security concern with respect to the stored data).

It will be noted that in some implementations utilizing a column multiplexing architecture that the ADC circuit in the processing circuit 20 could be shared by multiple columns. In this case, the operations being performed must be shifted (left or right) to compensate for the presence of the dummy column dC.

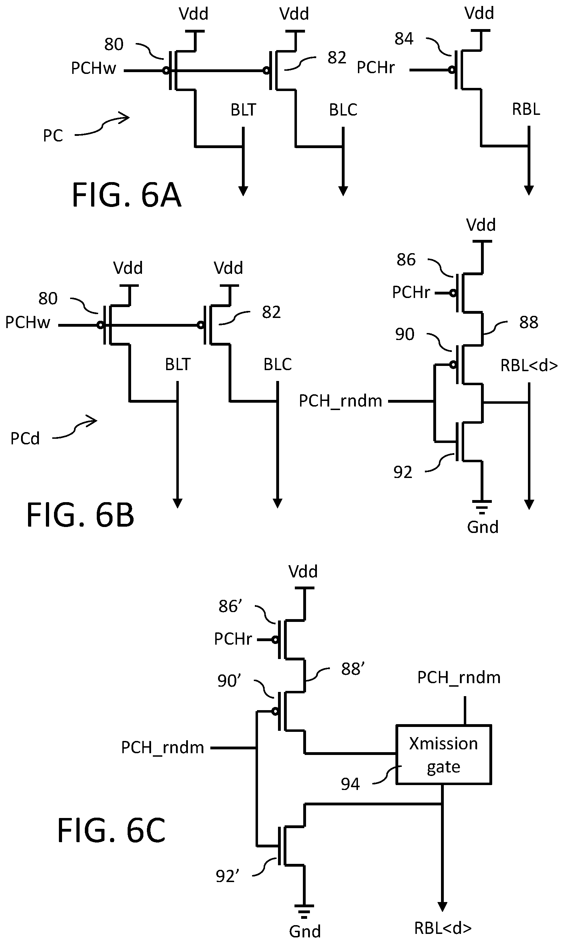

The memory array 12 further includes a bit line precharge circuit PC coupled to the complementary bit lines BLT, BLC and read bit line RBL of each normal (i.e., not dummy) column of the array. This precharge circuit PC operates to precharge a desired voltage level (for example, supply voltage Vdd) to the complementary bit lines BLT, BLC and read bit line RBL in advance of performing a data access (write or read or IMC) operation. Figure 6A shows circuit diagram for an example precharge circuit PC. The precharge circuit PC includes a first p-channel MOS transistor 80 having a source coupled to the supply voltage Vdd and a drain coupled to the bit line BLT, a second p-channel MOS transistor 82 having a source coupled to the supply voltage Vdd and a drain coupled to the bit line BLC, and a third p-channel MOS transistor 84 having a source coupled to the supply voltage Vdd and a drain coupled to the read bit line RBL. The gates of the transistors 80, 82 are driven by a write mode precharge control signal PCHw that is asserted (logic low) by the control circuit at the beginning of (i.e., in connection with the execution of) a memory access operation to write data into the memory array. The gate of transistor 84 is driven by a read/IMC mode precharge control signal PCHr that is asserted (logic low) by the control circuit at the beginning of (i.e., in connection with the execution of) a memory access operation to read data from the memory array or at the beginning of (i.e., in connection with the execution of) each in-memory computation operation.

The memory array 12 further includes a dummy bit line precharge circuit PCd coupled to the dummy complementary bit lines BLT, BLC and dummy read bit line RBL of each dummy column dC of the array. This precharge circuit PCd operates to precharge a desired voltage level (for example, supply voltage Vdd) to the complementary bit lines BLT, BLC in advance of performing a data access write operation. The circuit PCd further operates to randomly precharge the dummy read bit line RBL to one of a first voltage level (for example, supply voltage Vdd) and a second voltage level (for example, ground voltage Gnd) in advance of performing a data read operation or an in-memory computation operation. Figure 6B shows circuit diagram for an example precharge circuit PCd. The precharge circuit PCd includes a first p-channel MOS transistor 80 having a source coupled to the supply voltage Vdd and a drain coupled to the bit line BLT and a second p-channel MOS transistor 82 having a source coupled to the supply voltage Vdd and a drain coupled to the bit line BLC. The gates of the transistors 80, 82 are driven by a write mode precharge control signal PCHw that is asserted (logic low) by the control circuit at the beginning of (i.e., in connection with the execution of) a memory access operation to write data into the memory array. The precharge circuit PCd further includes a third p-channel MOS transistor 86 having a source coupled to the supply voltage Vdd and a drain coupled to an intermediate node 88, a fourth p-channel MOS transistor 90 having a source coupled to the intermediate node 88 and a drain coupled to the read bit line RBL, and an n-channel MOS transistor 92 having a drain coupled to the intermediate node 88 and a source coupled to the ground voltage Gnd. The gate of the transistor 86 is driven by the read/IMC mode precharge control signal PCHr that is asserted (logic low) by the control circuit at the beginning of (i.e., in connection with the execution of) a memory access operation to read data from the memory array or at the beginning of (i.e., in connection with the execution of) each in-memory computation operation. The gates of the transistors 90 and 92 are driven by a precharge control signal PCH_rndm at the beginning of a memory access operation to read data from the memory array or at the beginning of (i.e., in connection with the execution of) each in-memory computation operation. The logic state ("1" or "0") of the precharge control signal PCH_rndm is randomly generated by the control circuit using a random number generator (RNG) circuit at each instance of an access to the memory (read or IMC). When the precharge control signal PCH_rndm is logic "0", and the precharge control signal PCHr is asserted (logic low), the dummy read bit line RBL is precharged to the supply voltage Vdd and the dummy column dC contributes to the power consumption during the in-memory computation operation. On the other hand, when the precharge control signal PCH_rndm is logic "1", and the precharge control signal PCHr is asserted (logic low), the dummy read bit line RBL is precharged to the ground voltage Gnd and the dummy column dC does not contribute to the power consumption during the in-memory computation operation. Because the logic state of the precharge control signal PCH_rndm is randomly selected (using the random number generator RNG), there is a corresponding random participation of the dummy column dC in the in-memory computation operation, and this introduces a random variation in the power waveform of the in-memory computation device making it more difficult for a power-based side channel attack to succeed in discerning the stored computational weight data.

An alternative configuration for the precharge circuit PCd for the dummy read bit line RBL is shown in Figure 6C. A first p-channel MOS transistor 86' has a source coupled to the supply voltage Vdd and a drain coupled to the intermediate node 88'. A second p-channel MOS transistor 90' has a source coupled to the intermediate node 88' and a drain coupled to the input of a transmission gate circuit 94. An output of the transmission gate circuit 94 is coupled to the read bit line RBL. An n-channel MOS transistor 92' has a drain coupled to the read bit line RBL and a source coupled to the ground voltage Gnd. The gate of the transistor 86' is driven by the read/IMC mode precharge control signal PCHr that is asserted (logic low) in connection with defining the default state of the read bit line RBL before beginning (e.g., the execution of) a memory access operation to read data from the memory array or before beginning (e.g., the execution of) each in-memory computation operation. The gates of the transistors 90' and 92' are driven by a precharge control signal PCH_rndm at before beginning either a memory access operation to read data from the memory array or perform an in-memory computation operation. The precharge control signal PCH_rndm is also applied as an operational control signal for the transmission gate circuit 94. The logic state ("1" or "0") of the precharge control signal PCH_rndm is randomly generated using a random number generator (RNG) circuit at each instance of an access to the memory (read or IMC). The column can be configured for operation by enabling operation of (i.e., turning ON) the transmission gate circuit 94. However, when the transmission gate circuit 94 is turned OFF, the column is masked and the read bit line RBL is driven to the logic low state. When in the enabled configuration, with the precharge control signal PCH_rndm at logic "0", and the precharge control signal PCHr asserted (logic low), the dummy read bit line RBL is precharged to the supply voltage Vdd and the dummy column dC contributes to the power consumption during the read or in-memory computation operation. On the other hand, when the precharge control signal PCH_rndm is logic "1", and the precharge control signal PCHr is asserted (logic low), the dummy read bit line RBL is precharged to the ground voltage Gnd and the dummy column dC does not contribute to power consumption during the read or in-memory computation operation. Because the logic state of the precharge control signal PCH_rndm is randomly selected (using the random number generator RNG), there is a corresponding random participation of the dummy column dC in the in-memory computation operation, and this introduces a random variation in the power waveform of the in-memory computation device making it more difficult for a power-based side channel attack to succeed in discerning the stored computational weight data.

The digital computation circuit of the column processing circuit 20 may include a multiplexing functionality that would select for the computation processing only the outputs from the normal columns (i.e., by masking off output from the one or more dummy columns dC to ensure those outputs do not contribute the calculated decision). In cases with limited or shared ADC resources in the column processing circuit 20, this multiplexing functionality would be located between the array 12 and the inputs to the ADC circuits in order to select only output from the normal columns for input to the ADC circuits.

While the discussed implementation utilizes distinct dummy columns dC, it will be understood that the circuitry of the dummy columns could be implemented to enable support as normal operation columns. For example, this may be implemented in situations where increased bandwidth for in-memory computation operations is needed. In other words, the control circuit of the system may selectively configure certain columns as dummy columns in support of a given processing operation, and then change to have those same certain columns configured as normal columns in connection with supporting a different processing operation.

United States Patent Application Publication Nos. 2024/0071439 and 2024/0112728 are incorporated herein by reference. It will be understood that the in-memory computation systems shown in the referenced patent publications can be modified in the manner described herein to include the dummy column configuration and randomized bit line charging in support of inhibiting successful side channel attack.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

## Claims

1. A circuit, comprising:
a memory array including a plurality of memory cells arranged in a matrix with plural rows and plural columns, each row including at least one word line connected to memory cells in the row, and each column including at least one bit line connected to memory cells in the column;
wherein the memory cells store computational weight data for an in-memory computation operation;
wherein said plural columns include at least one dummy column;
a word line drive circuit for each row having an output configured to drive the word line of the row;
a row decoder circuit configured to actuate one or more of the word line drive circuits during execution of the in-memory computation operation; and
a bitline precharge circuit coupled to the at least one bit line of the at least one dummy column, wherein said bitline precharge circuit is configured to precharge said at least one bit line of the at least one dummy column to a randomly selected one of a first voltage level and a second voltage level, different from the first voltage level, in connection with execution of the in-memory computation operation.

2. The circuit of claim 1, wherein the first voltage level is a supply voltage level and the second voltage level is one of a ground voltage level or a floating level.

3. The circuit of claim 1, wherein the bitline precharge circuit comprises:
a first p-channel MOS transistor having a source coupled to the first voltage level, a drain coupled to an intermediate node, and a gate driven by a first precharge control signal;
a second p-channel MOS transistor having a source coupled to the intermediate node, a drain coupled to the at least one bit line of the at least one dummy column, and a gate driven by a second precharge signal having a randomly selected logic state; and
an n-channel MOS transistor having a drain coupled to the at least one bit line of the at least one dummy column, a source coupled to the second voltage level, and a gate driven by the second precharge signal;
wherein the second precharge signal is generated in response to a random number generator circuit.

4. The circuit of claim 3, wherein the drain of the second p-channel MOS transistor is coupled to the at least one bit line of the at least one dummy column through a transmission gate circuit controlled by said second precharge signal.

5. The circuit of claim 1, wherein the random selection of one of the first voltage level and second voltage level by the bitline precharge circuit is controlled by a precharge signal having a randomly selected logic state; and wherein the precharge signal is generated in response to a random number generator circuit.

6. The circuit of claim 1, further comprising:
an input/output circuit for each column that is coupled to the at least one bit line connected to memory cells in the column; and
a processing circuit configured to receive feature data for the in-memory computation and perform a computational operation as a function of the feature data and data generated by the input/output circuits for the columns.

7. The circuit of claim 1, wherein each memory cell is one of:
a static random access memory (SRAM) cell comprising one of a 6T-type cell or an 8T-type cell; or
a bitcell supporting read and write access.

8. The circuit of claim 1, wherein the in-memory computation operation is one of a digital in-memory computation or an analog in-memory computation.

9. The circuit of claim 1, wherein memory cells in said at least one dummy column store random data.

10. A circuit, comprising:
a memory array including a plurality of sub-arrays, wherein each sub-array includes memory cells arranged in a matrix with plural rows and plural columns, each row including a word line connected to the memory cells of the row, and each column including a local bit line connected to the memory cells of the column;
wherein the memory cells store computational weight data for an in-memory computation operation;
wherein said plural columns include at least one dummy column;
a word line drive circuit for each row having an output connected to drive the word line of the row;
a row decoder circuit coupled to the word line drive circuits;
a control circuit configured to control the row decoder circuit to simultaneously actuate one word line per sub-array during the in-memory computation operation; and
a bitline precharge circuit coupled to each local bit line in the at least one dummy column, wherein said bitline precharge circuit is configured to precharge the local one bit line in the at least one dummy column to a randomly selected one of a first voltage level and a second voltage level, different from the first voltage level, in connection with execution of the in-memory computation operation.

11. The circuit of claim 10, further comprising an input/output circuit for each column comprising:
a plurality of bit line inputs coupled to the local bit lines of the sub-arrays; and
a plurality of sub-array data outputs, where each sub-array data output is coupled to a corresponding one of the plurality of bit line inputs, and configured to generate a plurality of sub-array data bits for output.

12. The circuit of claim 11, wherein the input/output circuit for each column further comprises, between each bit line input and corresponding sub-array data output:
a first latch circuit and a first buffer circuit; and
a first multiplexing circuit having a first input coupled to the bit line input, an output coupled to the first latch circuit and the first buffer circuit, and a second input coupled to the output of the first multiplexing circuit;
wherein a selection input of the first multiplexing circuit is configured to receive a mode control signal, the first multiplexing circuit selecting the second input when the mode control signal is in a first state and selecting the first input when the mode control signal is in a second state.

13. The circuit of claim 12, wherein the input/output circuit for each column further comprises a read circuit coupled between the bit line input and the first input of the first multiplexing circuit.

14. The circuit of claim 11, further comprising a processing circuit configured to receive feature data and perform a computational operation for the in-memory computation operation as a function of the feature data and the plurality of sub-array data bits.

15. The circuit of claim 10, wherein the first voltage level is a supply voltage level and the second voltage level is one of a ground voltage level or a floating level.

16. The circuit of claim 10, wherein the bitline precharge circuit comprises:
a first p-channel MOS transistor having a source coupled to the first voltage level, a drain coupled to an intermediate node, and a gate driven by a first precharge control signal;
a second p-channel MOS transistor having a source coupled to the intermediate node, a drain coupled to the local bit line in the dummy column, and a gate driven by a second precharge signal having a randomly selected logic state; and
an n-channel MOS transistor having a drain coupled to the local bit line in the dummy column, a source coupled to the second voltage level, and a gate driven by the second precharge signal;
wherein the second precharge signal is generated in response to a random number generator circuit.

17. The circuit of claim 16, wherein the drain of the second p-channel MOS transistor is coupled to the local bit line in the dummy column through a transmission gate circuit controlled by said second precharge signal.

18. The circuit of claim 10, wherein each memory cell is one of:
a static random access memory (SRAM) cell comprising one of a 6T-type cell or an 8T-type cell;
a bitcell supporting read and write operations; or
a non-volatile memory cell with a deterministic output.

19. The circuit of claim 10, wherein memory cells in said at least one dummy column store random data.

20. A circuit, comprising:
a memory array including memory cells arranged in a matrix with plural rows and plural columns, each row including a word line connected to the memory cells of the row, and each column including a bit line connected to the memory cells of the column;
wherein the memory cells store computational weight data for an in-memory computation operation;
wherein said plural columns include at least one dummy column;
a word line drive circuit for each row having an output connected to drive the word line of the row;
a row decoder circuit coupled to the word line drive circuits;
a control circuit configured to control the row decoder circuit to simultaneously actuate plural ones of the word lines with word line signals having pulse widths modulated by feature data of the in-memory computation operation; and
a bitline precharge circuit coupled to the bit line in the at least one dummy column, wherein said bitline precharge circuit is configured to precharge the bit line in the at least one dummy column to a randomly selected one of a first voltage level and a second voltage level, different from the first voltage level, in connection with execution of the in-memory computation operation.

21. The circuit of claim 20, wherein the first voltage level is a supply voltage level and the second voltage level is one of a ground voltage level or a floating level.

22. The circuit of claim 20, wherein the bitline precharge circuit comprises:
a first p-channel MOS transistor having a source coupled to the first voltage level, a drain coupled to an intermediate node, and a gate driven by a first precharge control signal;
a second p-channel MOS transistor having a source coupled to the intermediate node, a drain coupled to the bit line in the dummy column, and a gate driven by a second precharge signal having a randomly selected logic state; and
an n-channel MOS transistor having a drain coupled to the bit line in the dummy column, a source coupled to the second voltage level, and a gate driven by the second precharge signal;
wherein the second precharge signal is generated in response to a random number generator circuit.

23. The circuit of claim 22, wherein the drain of the second p-channel MOS transistor is coupled to the bit line in the dummy column through a transmission gate circuit controlled by said second precharge signal.

24. The circuit of claim 20, wherein each memory cell is one of:
a static random access memory (SRAM) cell; or
a bitcell supporting read and write operations.

25. The circuit of claim 20, further comprising:
analog-to digital converter circuitry coupled process analog signals on the bit lines of the columns; and
digital computation circuitry coupled to process digital signals output from the analog-to digital converter circuitry to generate a decision output for the in-memory computation operation.

26. The circuit of claim 20, wherein memory cells in said at least one dummy column store random data.
